# FASCICULE DE BREVET EUROPEEN

(11) **EP 2 567 407 B1**
(45) Date de publication et mention de la délivrance du brevet: **19.03.2014**
(21) Numéro de dépôt: 11722846.0
(22) Date de dépôt: 29.04.2011
(51) Int. Cl.: H01L 31/0224, H01L 31/042, H01L 31/18

(54) **CELLULE PHOTOVOLTAÏQUE COMPORTANT UNE ZONE SUSPENDUE PAR UN MOTIF CONDUCTEUR ET PROCÉDÉ DE RÉALISATION**
PV-ZELLE MIT EINEM ANHAND EINER LEITENDEN STRUKTUR HÄNGENDEN BEREICH UND HERSTELLUNGSVERFAHREN
PHOTOVOLTAIC CELL COMPRISING A REGION SUSPENDED BY A CONDUCTIVE PATTERN AND PRODUCTION PROCESS

(30) Priorité: 06.05.2010 FR 1001948
(43) Date de publication de la demande: 13.03.2013
(73) Titulaire: Commissariat à l'Énergie Atomique et aux Énergies Alternatives, 75015 Paris (FR)
(72) Inventeur: CABAL, Raphaël, F-24000 Périgueux (FR); GRANGE, Bernadette, F-73000 Chambery (FR)
(74) Mandataire: Talbot, Alexandre
(86) Numéro de dépôt international: PCT/FR2011/000264
(87) Numéro de publication internationale: WO 2011/138519

(56) Documents cités:
- EP-A1- 0 999 598
- EP-A1- 1 763 086
- WO-A2-2009/121604
- US-A1- 2006 130 891
- US-A1- 2009 101 190
- US-B1- 6 262 359

## Description

### Domaine technique de l'invention

L'invention est relative à une cellule photovoltaïque comportant :
- un substrat,
- une couche de collection, électriquement conductrice,
- un film de passivation, électriquement conducteur, séparant la couche de collection du substrat,

L'invention est également relative à un procédé de réalisation d'une cellule photovoltaïque.

### État de la technique

La cellule photovoltaïque est constituée par une multitude de couches aux propriétés bien spécifiques dans laquelle chaque couche utilisée a pour objet une fonction électrique ou mécanique bien précise. Ses couches apportent, par exemple, un gain de fonctionnement sur la réflexion du rayonnement incident ou sur la tenue dans le temps ou encore sur la résistance série. Cependant, chaque couche et/ou chaque étape technologique n'est pas neutre et engendre des contraintes mécaniques ou technologiques sur les éléments déjà intégrés ou sur les éléments à venir.

De manière conventionnelle, une cellule photovoltaïque comporte un substrat muni d'une jonction photovoltaïque. Ainsi, le rayonnement lumineux frappe la cellule photovoltaïque et il est converti en un courant électrique qui est collecté par des contacts électriques. Les contacts sont disposés sur les faces principales, de part et d'autre du substrat, pour permettre la sortie du courant généré par la cellule photovoltaïque.

Afin d'augmenter les performances des cellules photovoltaïques et la viabilité de l'industrie solaire, la tendance est à l'amincissement de la cellule et à l'utilisation de surfaces de collection toujours plus grandes. Dans ces conditions, au fur et à mesure de l'élaboration de la cellule, des transformations sont opérées sur les cellules photovoltaïques et les contraintes mécaniques générées sont telles que la cellule n'est plus plane.

Ce défaut de planéité est un inconvénient de première importance car cela limite fortement les possibilités d'intégration des cellules dans des panneaux qui sont majoritairement plans et cela rend plus difficile l'automatisation de la production.

L'article de Huster (« Aluminium-Back Surface Field : Bow Investigation and Elimination », 20th European Photovoltaic Solar Energy Conference and Exhibition, Barcelona 6-10 June 2005) décrit une cellule dont la face arrière est recouverte par une couche en alliage de silicium et d'aluminium. Cette couche en silicium et aluminium introduit une déformation de la cellule photovoltaïque. Afin d'éliminer ou de réduire cette déformation de la cellule, l'auteur réalise, après une étape de recuit, une trempe de la cellule dans la gamme (-20°C ; -50°C).

Cette approche académique ne paraît pas réalisable d'un point de vue industriel et il est donc nécessaire de trouver une alternative à cette voie afin d'obtenir des cellules photovoltaïques dont la planéité est compatible avec une utilisation en grande série.

### Objet de l'invention

L'objet de l'invention consiste à réaliser une cellule photovoltaïque qui soit plane ou sensiblement plane.

On tend à résoudre ce problème au moyen d'une cellule selon les revendications annexées et en particulier par le fait qu'un motif de connexion, électriquement conducteur, maintient en suspension une zone de la couche de collection par rapport au film de passivation.

L'invention a également pour objet un procédé qui soit facile à mettre en oeuvre et qui assure la réalisation de cellules photovoltaïques planes.

On tend à résoudre ce problème au moyen d'un procédé selon les revendications annexées et en particulier par le fait que le procédé comporte les étapes suivantes :
- prévoir un substrat muni d'une jonction photovoltaïque et recouvert sur une face principale par un film de passivation électriquement conducteur, une zone en matériau sacrificielle et une couche de collection électriquement conductrice,
- dégrader la zone sacrificielle pour former une zone suspendue dans la couche de collection et un motif de connexion.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 et 2 représentent, de manière schématique, en coupe, différents modes de réalisation d'une cellule photovoltaïque,
- les figures 3 à 5 représentent, de manière schématique, en coupe, différentes étapes d'un procédé de réalisation d'une cellule photovoltaïque,
- les figures 6 et 7 représentent, de manière schématique, en coupe, d'autres étapes relatives à des variantes de procédés de réalisation d'une cellule photovoltaïque.

### Description d'un mode de réalisation préférentiel de l'invention

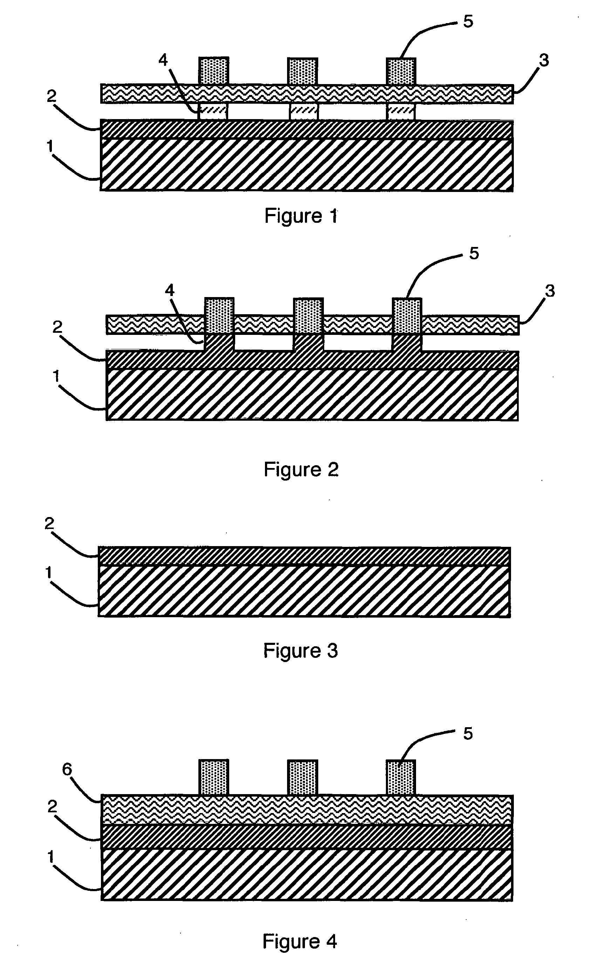

Comme cela est illustré aux figures 1 et 2, la cellule photovoltaïque comporte un substrat 1 muni d'une jonction photovoltaïque. Le substrat 1 comporte, pour sa part, des première et seconde faces principales opposées. La première face principale est d'un côté de la jonction photovoltaïque alors que la seconde face principale est de l'autre côté de la jonction.

Une partie de l'énergie lumineuse qui frappe la cellule photovoltaïque depuis une des faces principales, la face avant, est transformée en porteurs de charge électrique au moyen de la jonction photovoltaïque. Le substrat 1 est, par exemple, un substrat 1 en matériau semi-conducteur cristallin, de manière plus précise un substrat 1 en silicium monocristallin ou polycristallin.

La jonction photovoltaïque est réalisée dans le substrat 1 par toute technique adaptée. A titre d'exemple, pour un substrat 1 en silicium ou à base de silicium ou de germanium de type p, il y a un dopage de type opposé (ici de type n) réalisé sur une des faces principales. Ainsi, dans le substrat 1, il y a une partie dopée de type p et une partie dopée de type n ce qui permet de réaliser la jonction photovoltaïque recherchée. Les profils des différents dopants peuvent évoluer, spatialement, de manière à favoriser l'effet photovoltaïque ou la résistance de contact du substrat 1 selon les endroits.

La face principale du substrat qui sert de face avant à la cellule photovoltaïque est munie de contacts conducteurs (non représentés) qui permettent la sortie du courant électrique produit dans la cellule. Les contacts sont, de préférence, réalisés dans des matériaux présentant une faible résistivité afin de limiter les résistances d'accès et ainsi ne pas pénaliser le fonctionnement de la cellule. A titre d'exemple, les contacts sont en matériau métallique, plus précisément à base d'argent.

L'autre face principale qui sert de face arrière est également munie de contacts conducteurs qui permettent la sortie du courant électrique produit dans la cellule. Les contacts conducteurs disposés sur les faces principales opposées représentent les deux bornes de sortie de la cellule photovoltaïque. A titre d'exemple, les contacts de la face arrière sont en matériau métallique, plus précisément à base d'argent et/ou d'aluminium. Les contacts conducteurs sont connectés électriquement au substrat 1 par l'intermédiaire de différentes couches électriquement conductrices.

Les contacts conducteurs sont réalisés par toute technique adaptée, par exemple par sérigraphie. Il est également possible d'utiliser un dépôt suivi d'une gravure de localisation du conducteur. Lorsque les contacts sont formés par sérigraphie, le substrat 1 est ensuite soumis à un traitement thermique afin d'éliminer le solvant associé aux contacts. De manière préférentielle, les contacts sont formés par sérigraphie car cela permet une réduction des coûts et cela facilite le positionnement des contacts sur les faces du substrat 1.

Afin de profiter d'un effet de champ sur la face arrière (Back Surface Field en anglais), la surface arrière du substrat 1 est recouverte par un film de passivation 2 électriquement conducteur qui est plus conducteur que le substrat. Le film de passivation 2 permet de réduire la recombinaison entre les électrons et les trous au niveau de la face arrière du substrat 1 ce qui améliore le rendement de la cellule photovoltaïque.

Ce film de passivation 2 peut être formé par une couche dopée du substrat 1 ou une couche plus fortement dopée du substrat 1, c'est-à-dire en matériau semi-conducteur. A titre d'exemple, si le substrat 1 est de type p, la face avant est dopée de type n pour former la jonction photovoltaïque et la face arrière est dopée de type p+, c'est-à-dire de type p avec une concentration plus importante de dopants actifs que dans la partie du substrat 1 directement en contact avec le film de passivation 2.

Le dopage est obtenu au moyen d'impuretés dopantes, par exemple, le bore ou l'aluminium pour un substrat de type p. Le film de passivation comporte au moins un film semi-conducteur dopé, de préférence du même matériau que celui qui forme le substrat.

La cellule photovoltaïque comporte également une couche de collection 3 en matériau électriquement conducteur. Cette couche de collection 3 présente une résistivité plus faible que celle du substrat 1 et du film 2. De manière préférentielle, la résistivité des matériaux diminue au fur et à mesure que l'on s'éloigne de la jonction photovoltaïque vers les contacts conducteurs de la face arrière.

Au niveau de la face arrière de la cellule, la couche de collection 3 en matériau conducteur permet de faciliter l'extraction du courant. La couche de collection 3 électriquement conductrice est avantageusement en matériau métallique, c'est-à-dire un métal pur ou un alliage de métaux. La couche de collection 3 est séparée du substrat 1 par le film de passivation 2.

Afin de réduire les contraintes exercées par la couche de collection 3 sur le substrat 1, cette dernière est suspendue ou au moins partiellement suspendue, c'est-à-dire que la couche de collection 3 est solidaire du substrat au moyen d'un ou plusieurs motifs de connexion 4 et elle comporte au moins une zone suspendue. De ce fait, il y a au moins une zone sans transfert de contrainte entre le film de passivation 2 et la couche de collection 3. Cette zone particulière est, par exemple, une zone vide ou une zone remplie par un fluide.

La cellule photovoltaïque comporte une cavité déformable délimitée d'un côté par le film de passivation 2 et sur le côté opposé par la couche de collection 3. Selon les modes de réalisation, la cavité peut être délimitée latéralement par un motif de connexion périphérique fermé et/ou elle peut inclure un motif de connexion 4. Selon l'organisation des zones vides et des motifs de connexion 4, les différentes zones vides peuvent être délimitées par les parois latérales des motifs de connexion. De ce fait, une zone vide est entourée par un motif de connexion. A l'inverse, dans un autre mode de réalisation, les différentes zones vides visibles dans la vue de coupe communiquent entre elles et cela représente un ou plusieurs motifs de connexion distincts séparés par une zone vide.

Le motif de connexion 4 maintient alors une zone de la couche de collection 3 en suspension par rapport au film de passivation 2. La cellule photovoltaïque est donc une cellule qui comporte des cavités d'air ou d'un autre fluide, de préférence un gaz à l'intérieur de sa structure. Si plusieurs motifs 4 sont formés, il en faut au moins un qui soit électriquement conducteur pour assurer la connexion électrique entre le substrat 1 et la couche de collection 3

Le motif de connexion 4 peut être formé par tout matériau électriquement conducteur. De manière préférentielle, le motif de connexion est formé à partir du film de passivation 2, de la couche de collection 3, d'un autre matériau ou d'une combinaison de ces cas. Ceci permet de limiter la complexité du procédé de réalisation et les problèmes de compatibilité physico-chimique entre les matériaux.

La couche de collection 3 est en contact électrique avec le substrat 1 par l'intermédiaire des motifs de connexion 4 en matériau électriquement conducteur. Les motifs de connexion 4 ont des parois latérales non recouvertes. Ces parois latérales vont du film de passivation 2 jusqu'à la couche de collection 3.

Cette architecture particulière permet ainsi de limiter l'influence mécanique de la couche de collection 3 en limitant sa surface de contact avec le substrat 1 par l'intermédiaire des motifs de connexion 4. Il faut cependant conserver une surface de contact suffisante pour assurer le passage du courant et empêcher la délamination de la couche de collection 3. L'étendue de la surface de contact et sa répartition sur la face arrière dépend des propriétés mécaniques et électriques des matériaux constituant le film de passivation 2, la couche de collection 3 et le motif de connexion 4.

Le motif de connexion 4 est un élément qui est en saillie de la couche de collection 3 et du film de passivation 2 de manière à empêcher le contact direct entre ces deux couches.

Le motif de connexion 4 peut provenir de la formation d'une zone en saillie du film de passivation 2. Il peut également provenir de la formation d'une zone en saillie de la couche de collection 3. Il peut encore être formé à partir d'un autre matériau électriquement conducteur disposé entre le film de passivation 2 et la couche de collection 3. Il est également envisageable de combiner plusieurs de ces modes de réalisation précédents.

Ainsi, le motif de connexion 4 peut être formé par un matériau semi-conducteur dopé, par un matériau métallique ou par un matériau à caractère métallique tel qu'un alliage entre un matériau métallique et un matériau semi-conducteur. La distance séparant la couche de collection 3 du film de passivation 2 peut être comprise entre quelques nanomètres et quelques centaines de micromètres. De manière préférentielle, la distance est comprise entre un et cinquante micromètres.

Si plusieurs motifs de connexion 4 sont intégrés, les différents motifs peuvent présenter entre eux des différences dimensionnelles en ce qui concerne la longueur, la largeur et la hauteur du motif. Les différents motifs peuvent également présenter des différences de composition chimique. A titre d'exemple, certains motifs sont en matériau semi-conducteur alors que d'autres sont en alliage d'un matériau semi-conducteur avec un matériau métallique.

Comme cela est illustré à la figure 1, les motifs de connexion 4 sont formés par un matériau différent de celui formant la couche de collection 3 et de celui formant le film de passivation 2.

Comme cela est illustré à la figure 2, les motifs de connexion 4 sont formés dans le même matériau que celui formant le film de passivation 2.

Si plusieurs motifs de connexion 4' sont intégrés, il est envisageable que certains servent essentiellement au maintien mécanique alors que d'autres servent majoritairement au transit du courant électrique.

A titre d'exemple, la couche de collection 3 est en aluminium et/ou en argent, et le film de passivation 2 est en silicium dopé p+.

De manière préférentielle, si la couche de collection 3 comporte des zones ayant des résistivités différentes, par exemple des zones poreuses et non poreuses, des zones ayant des taux de remplissage variables ou des zones formées par des matériaux différents, les motifs de connexion 4 sont associés aux zones ayant la résistivité la plus faible.

Le motif de connexion 4 a une surface commune avec le film de passivation 2 et une surface opposée commune avec la couche de collection 3. Ces deux parois opposées sont de part et d'autre du motif 4 et sont, de préférence, équivalentes ou sensiblement équivalentes dans leur étendue.

La couche de collection 3 peut être formée par un matériau métallique unique, par différents matériaux métalliques disposés les uns à côté des autres ou alors par un alliage en matériau métallique. Ainsi, comme cela est illustré à la figure 1, la couche de collection 3 peut être formée par une couche en un premier matériau métallique, par exemple de l'aluminium. Des motifs 5 électriquement conducteurs, dans un second matériau métallique, par exemple de l'argent (figure 1) sont formés sur la couche de collection. Il est également possible d'avoir une couche 3 formée par un premier matériau métallique avec des inclusions en second matériau métallique (figure 2), par exemple les motifs 5.

L'obtention d'une couche de collection 3 suspendue et maintenue solidaire du reste de la cellule par un ou plusieurs motifs de connexion 4 est alors particulièrement avantageuse pour la maîtrise des contraintes dans la cellule.

L'obtention d'une cellule photovoltaïque provient d'un procédé simple à mettre en oeuvre et qui utilise peu d'étapes spécifiques par rapport à un procédé conventionnel.

La jonction photovoltaïque est obtenue par tout procédé classique. Les étapes relatives à la formation de la face avant de la cellule ne sont pas modifiées et ne sont donc pas représentées. De manière préférentielle, les différentes étapes technologiques relatives à la face avant sont formées avant celles de la face arrière. Cependant, il est possible de réaliser certaines étapes de la face avant préalablement ou pendant celles de la face arrière et inversement.

Comme illustré à la figure 3, un film de passivation 2 est formé par toute technique adaptée sur la face arrière du substrat 1. De manière préférentielle, le film de passivation 2 est formé par dopage du substrat 1. Ce dopage peut être réalisé par implantation ionique ou par un traitement thermique sous une atmosphère dopante. II est également possible de déposer un matériau semi-conducteur dopé.

Comme cela est illustré à la figure 4, la formation du film de passivation 2 est ensuite suivie du dépôt d'un matériau de collection 6 qui va former la couche de collection 3. Le matériau de collection 6 peut être formé par toute technique adaptée.

Dans un mode de réalisation préférentiel, l'ordre des étapes est inversé. Le film de passivation 2 est obtenu par dépôt puis recuit d'une couche dopante, par exemple de l'aluminium. Ce recuit de la couche dopante forme simultanément la couche de collection en aluminium, une couche en alliage d'aluminium et silicium et une couche de passivation 3 en silicium dopée par des atomes d'aluminium. Cette succession de couches provient de la diffusion des atomes de silicium et d'aluminium lors du recuit.

Le matériau de collection 6 est typiquement un matériau métallique ou un alliage de matériaux métalliques déposé sur le film de passivation. Ce matériau de collection 6 est ensuite soumis à un traitement thermique afin de le faire partiellement réagir avec le film de passivation 2 pour former un film de connexion 7. Ainsi, une partie de l'épaisseur du matériau de collection 6 forme le film de connexion 7 tandis que le reste du matériau forme la couche de collection 3.

Le film de connexion 7 est ensuite gravé partiellement de manière à former au moins un motif de connexion 4 et une zone suspendue dans la couche de collection 3. II en ressort que le motif de connexion 4 est formé en un alliage entre un matériau métallique et le matériau semi-conducteur (le film de connexion 7).

Dans ce mode de réalisation, la gravure partielle du film de connexion 7 permet de former des motifs de connexion 4 qui participent au transit du courant. La gravure du film de connexion 7 est réalisée par toute technique adaptée, par exemple par voie humide ou gazeuse, en structurant la couche de collection 3 ou en utilisant des particularités structurelles de cette dernière.

Si la couche de collection 3 présente des inhomogénéités dans la perméabilité à l'agent de dégradation, les motifs de connexion 4 peuvent être obtenus facilement en utilisant des différences de comportement.

Si la couche de collection 3 est relativement homogène et/ou pour préciser le positionnement des motifs de connexion 4, la couche de collection 3 est partiellement recouverte par un ou plusieurs motifs de protection 5.

De manière préférentielle, la couche de collection 3 est formée par un matériau perméable à un agent de dégradation de la couche 7 et au sous-produit de dégradation. Cette perméabilité permet de faire passer un agent de dégradation à travers la couche de collection 3. Ainsi, le matériau sacrificiel est éliminé par l'agent de dégradation ce qui forme des zones vides et les zones suspendues de la couche de collection 3.

La localisation de la dégradation du matériau sacrificiel par l'agent de dégradation est maîtrisée au moyen de motifs de protection. Les motifs de protection sont formés à la surface de la couche de collection et rendent certaines portions imperméables à l'agent de dégradation. Le positionnement et l'étendu de ces motifs de protection permet alors de définir les motifs de connexion 4 en matériau sacrificiel. La couche de collection 3 est formée, de préférence, par un matériau ayant un taux de remplissage inférieur à 70% et elle est remplie partiellement par le motif de protection 5 dans la zone à protéger.

Si les motifs de protection 5 sont conducteurs électriquement, ils peuvent servir également de contacts conducteurs pour la cellule photovoltaïque.

Si la perméabilité à l'agent de dégradation et au sous-produit de dégradation n'est pas une caractéristique intrinsèque de la couche de collection, il est possible de rendre perméable une partie seulement de la couche. Dans ces conditions, les motifs de protection 5 peuvent être évités.

De manière préférentielle, la perméabilité de la couche de collection est obtenue en utilisant une couche poreuse ou comportant des zones poreuses. Cependant, il est également envisageable de former des trous, des canaux de circulation, à l'intérieur de la couche de collection pour dégrader le matériau sacrificiel.

L'utilisation d'un agent de dégradation passant au travers d'une couche de collection 3 perméable et d'un motif de protection 5 conducteur imperméable permet de réaliser l'auto-alignement des contacts conducteurs avec les motifs de connexion 4. Ainsi, le chemin parcouru par le courant pour sortir de la cellule est minimal et le procédé de réalisation est simple.

A titre d'exemple, si le matériau de collection 6 est en aluminium ou contient des zones en aluminium, le matériau sacrificiel est en alliage de silicium et d'aluminium et l'agent de dégradation est une solution à base d'acide chlorhydrique ou uniquement de l'acide chlorhydrique.

Les motifs de protection sont formés dans des matériaux qui ne réagissent pas ou qui réagissent peu à l'agent de gravure de manière à éviter l'élimination du film sacrificiel immédiatement sous le motif de protection. Les dimensions et la forme des motifs de connexion sont fonction du mode de dégradation utilisé et des dimensions des motifs de protection.

Le matériau de protection est, par exemple, un oxyde de silicium formé par toute technique adaptée, par exemple par sérigraphie. L'épaisseur du matériau de protection est avantageusement supérieure ou égale à 10µm.

En cas de formation d'un oxyde de silicium par sérigraphie, un recuit est avantageusement réalisé afin de le stabiliser. A titre d'exemple, un recuit de l'ordre de 5 minutes entre 100°C et 200°C est suffisant pour la stabilisation de l'oxyde de silicium.

Ainsi, le motif de connexion 4 et le motif de protection 5 sont disposés, en regard, de part et d'autre de la couche de collection 3 et présentent une surface de contact équivalente avec la couche de collection 3.

Le motif de protection 5 peut être dans un matériau conducteur ou dans un matériau isolant électriquement, par exemple en argent, en oxyde de silicium ou en nitrure de silicium.

Dans un second mode de réalisation, le ou les motifs de protection 5 sont formés avant le matériau de collection 6. De ce fait, les motifs 5 sont en contact direct avec le film de passivation 2. Le matériau de collection peut recouvrir les motifs de protection ou les laisser apparents. Il existe alors des zones dans lesquelles le matériau de collection 6 est en contact direct avec le film de passivation 2 et des zones dans lesquelles ce contact est impossible à cause du motif de protection 2.

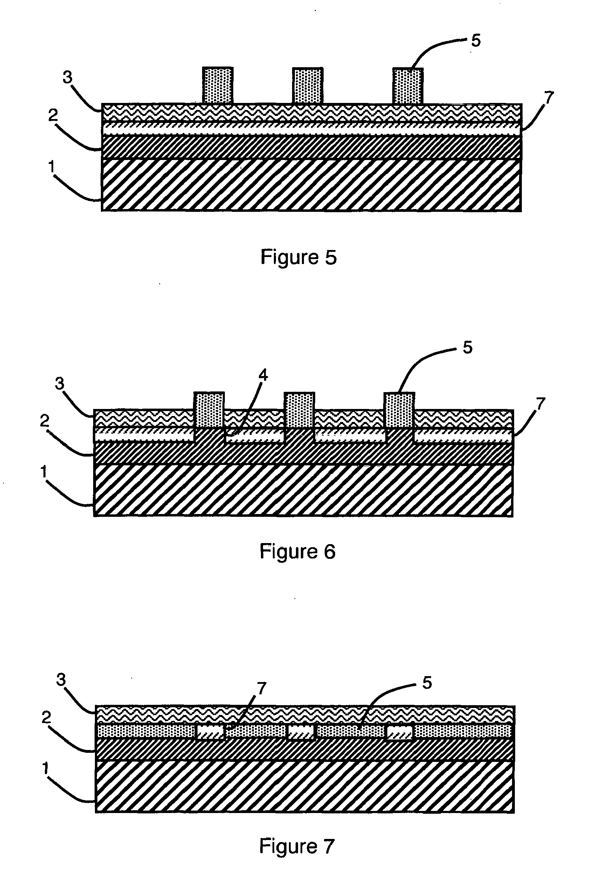

Si un traitement thermique est effectué, le matériau de collection 6 réagit avec le film de passivation 2 sauf dans les endroits recouverts par les motifs de protection 5. De cette manière, le film de connexion 7 sépare la couche de collection 3 du film de passivation 2 sauf dans les zones recouvertes par les motifs 5, comme c'est illustré aux figures 6 et 7

Dans un premier cas de figure, la gravure partielle ou totale du film de connexion 7 permet d'aboutir à la structure suspendue. La couche de collection 3 est maintenue au-dessus du film de passivation 2 par les motifs de protection qui agissent comme des motifs de connexion et éventuellement par des zones non gravées du film de connexion 7 (figure 3).

Selon que le matériau de collection 6 recouvre ou non (figures 6 et 7) les motifs de connexion, le maintien mécanique est réalisé soit par la face supérieure du motif de connexion soit par les faces latérales.

Dans un second cas de figure, le film de connexion 7 agit comme motif de connexion et le motif de protection 5 recouvert par la couche de collection est éliminé au moins partiellement (figure 7). La couche de collection 3 est alors suspendue au moyen des zones en film de connexion 7 et éventuellement au moyen de motifs de protection (figure 1).

II est encore possible de combiner ces deux approches afin de fonctionnaliser la face arrière. Par exemple, si les motifs de protection sont formés dans un matériau isolant, ils ne servent qu'au maintien mécanique.

Ce mode de réalisation est particulièrement intéressant car il n'y a pas besoin de maîtriser les conditions de la gravure, en effet l'agent de dégradation élimine un seul matériau, le matériau sacrificiel.

De manière préférentielle, les motifs de connexion additionnels sont formés perpendiculairement aux motifs de protection 5 conducteurs dans un plan parallèle à la surface du substrat 1. De manière encore plus préférentielle, les zones additionnelles relient deux zones associées à des contacts adjacents. Cette disposition particulière permet de réduire les risques de délamination et d'éviter des variations au niveau des lignes de champ présentes en face arrière.

Ainsi, pour obtenir une cellule photovoltaïque ayant une portion suspendu, il faut prévoir un substrat 1 muni d'une jonction photovoltaïque et recouvert sur une face principale par le film de passivation 2, une zone en matériau sacrificielle et la couche de collection. La zone en matériau sacrificielle peut être le film de connexion ou une partie de ce dernier ou un motif de protection. II faut ensuite dégrader la zone sacrificielle pour former une zone suspendue dans la couche de collection 3 et un motif de connexion 4 entre le film de passivation 2 et la couche de collection 3.

## Revendications

1. Cellule photovoltaïque comportant :
- un substrat (1) comportant une jonction photovoltaïque,
- une couche de collection (3), électriquement conductrice,
- un film de passivation (2), électriquement conducteur, séparant la couche de collection (3) d'une face arrière du substrat (1),
cellule **caractérisée en ce qu'**un motif de connexion (4), électriquement conducteur, maintient en suspension une zone de la couche de collection (3) par rapport au film de passivation (2).

2. Cellule selon la revendication 1, **caractérisée en ce que** le film de passivation (2) est en matériau semi-conducteur.

3. Cellule selon l'une des revendications 1 et 2, **caractérisée en ce qu'**elle comporte un motif de connexion (4) dans un alliage de matériau semi-conducteur et de matériau métallique.

4. Cellule selon l'une des revendications 1 et 2, **caractérisée en ce que** la couche de collection (3) est en matériau semi-conducteur.

5. Cellule selon l'une quelconque des revendications 1 à 4, **caractérisée en ce que** la couche de collection (3) est partiellement recouverte par un motif de protection (5) et **en ce que** le motif de connexion (4) et le motif de protection (5) sont disposés, en regard, de part et d'autre de la couche de collection (3).

6. Cellule selon la revendication 5, **caractérisé en ce que** la couche de collection (3) est formée par un matériau poreux et remplie partiellement par le motif de protection.

7. Cellule selon l'une quelconque des revendications 1 à 6, **caractérisée en ce qu'**elle comporte :
- un substrat (1) en silicium,
- un film de passivation (2) en silicium dopé de type p,
- une couche de collection (3) en aluminium,
- des motifs de protection (5) en oxyde de silicium,
- un motif de connexion (4) en en alliage de silicium-aluminium.

8. Procédé de réalisation d'une cellule photovoltaïque **caractérisée en ce qu'**il comporte les étapes suivantes :
- prévoir un substrat (1) muni d'une jonction photovoltaïque et recouvert sur une face arrière par un film de passivation (2) électriquement conducteur, une zone en matériau sacrificiel et une couche de collection (3) électriquement conductrice,
- dégrader la zone sacrificielle pour former une zone suspendue dans la couche de collection (3) et un motif de connexion (4) entre le film de passivation (2) et la couche de collection(3).

9. Procédé selon la revendication 8, **caractérisé en ce que** la zone sacrificielle est en alliage d'aluminium et de silicium et est dégradée par une solution d'acide chlorhydrique à travers une zone perméable de la couche de collection (3).

10. Procédé selon la revendication 9, **caractérisé en ce que** la couche de collection (3) et les motifs de protection (5) sont déposés par sérigraphie.

## Patentansprüche

1. Photovoltaikzelle, aufweisend:
- ein Substrat (1), das einen photovoltaischen Übergang umfasst,
- eine elektrisch leitende Sammelschicht (3),
- einen elektrisch leitenden Passivierungsfilm (2), der die Sammelschicht (3) von einer Rückseite des Substrats (1) trennt,
Zelle, die **dadurch gekennzeichnet ist, dass** ein elektrisch leitendes Verbindungsmuster (4) einen Bereich der Sammelschicht (3) gegenüber dem Passivierungsfilm (2) hängend hält.

2. Zelle nach Anspruch 1, **dadurch gekennzeichnet, dass** der Passivierungsfilm (2) aus Halbleitermaterial besteht.

3. Zelle nach einem der Ansprüche 1 und 2, **dadurch gekennzeichnet, dass** sie ein Verbindungsmuster (4) aus einer Legierung aus Halbleitermaterial und aus metallischem Material umfasst.

4. Zelle nach einem der Ansprüche 1 und 2, dadurch gekenntzeichnet, dass die Sammelschicht (3) aus Halbleitermaterial besteht.

5. Zelle nach einem der Ansprüche 1 bis 4, **dadurch gekennzeichnet, dass** die Sammelschicht (3) teilweise von einem Schutzmuster (5) bedeckt ist und dass das Verbindungsmuster (4) und das Schutzmuster (5) auf beiden Seiten der Sammelschicht (3) gegenüberliegend angeordnet sind.

6. Zelle nach Anspruch 5, **dadurch gekennzeichnet, dass** die Sammelschicht (3) durch ein poröses Material gebildet und teilweise durch das Schutzmuster gefüllt ist.

7. Zelle nach einem der Ansprüche 1 bis 6, dadurch gekenntzeichnet, dass sie umfaßt:
- ein Substrat (1) aus Silizium,
- einen Passivierungsfilm (2) aus p-dotiertem Silizium,
- eine Sammelschicht (3) aus Aluminium,
- Schutzmuster (5) aus Siliziumoxid,
- ein Verbindungsmuster (4) aus einer Silizium-Aluminium-Legierung.

8. Verfahren zur Herstellung einer Photovoltaikzelle, **dadurch gekennzeichnet, dass** es die folgenden Schritte umfasst:
- Vorsehen eines Substrats (1), das mit einem photovoltaischen Übergang versehen ist und auf einer Rückseite von einem elektrisch leitenden Passivierungsfilm (2), einem Bereich aus Opfermaterial und einer elektrisch leitenden Sammelschicht (3) bedeckt ist,
- Abbauen des Opferbereichs, um einen hängenden Bereich in der Sammelschicht (3) und ein Verbindungsmuster (4) zwischen dem Passivierungsfilm (2) und der Sammelschicht (3) zu bilden.

9. Verfahren nach Anspruch 8, **dadurch gekennzeichnet, dass** der Opferbereich aus einer Legierung aus Aluminium und Silizium besteht und durch eine Satzsäurelösung durch einen durchlässigen Bereich der Sammelschicht (3) abgebaut wird.

10. Verfahren nach Anspruch 9, **dadurch gekennzeichnet, dass** die Sammelschicht (3) und die Schutzmuster (5) mittels Siebdruck aufgebracht werden.

## Claims

1. A photovoltaic cell comprising:
- a substrate (1) comprising a photovoltaic junction,
- an electrically conductive collection layer (3),
- an electrically conductive passivation film (2) separating the collection layer (3) from a back face of the substrate (1),
cell **characterized in that** an electrically conductive connection pattern (4) maintains an area of the collection layer (3) in suspension with respect to the passivation film (2).

2. The cell according to claim 1, **characterized in that** the passivation film (2) is made from semiconductor material.

3. The cell according to one of claims 1 and 2, **characterized in that** it comprises a connection pattern (4) made from an alloy of semiconductor material and of metallic material.

4. The cell according to one of claims 1 and 2, **characterized in that** the collection layer (3) is made from semiconductor material.

5. The cell according to any one of claims 1 to 4, **characterized in that** the collection layer (3) is partially covered by a protection pattern (5) and **in that** the connection pattern (4) and the protection pattern (5) are arranged facing one another on each side of the collection layer (3).

6. The cell according to claim 5, **characterized in that** the collection layer (3) is formed by a porous material and partially filled by the protection pattern,

7. The cell according to any one of claims 1 to 6, **characterized in that** it comprises:
- a silicon substrate (1 ),
- a passivation film (2) made from p-doped silicon,
- an aluminium collection layer (3),
- protection patterns (5) made from silicon oxide,
- a connection pattern (4) made from a silicon-aluminium alloy.

8. A method for producing a photovoltaic cell **characterized in that** it comprises the following steps:
- providing a substrate (1) provided with a photovoltaic junction and covered on a back surface by an electrically conductive passivation film (2), a sacrificial material area and an electrically conductive collection layer (3),
- etching the sacrificial area so as to form a suspended area in the collection layer (3) and a connection pattern (4) between the passivation film (2) and the collection layer (3).

9. The method according to claim 8, **characterized in that** the sacrificial area is made from aluminium and silicon alloy and is etched by a hydrochloric acid solution through a permeable area of the collection layer (3).

10. The method according to claim 9, **characterized in that** the collection layer (3) and the protection patterns (5) are deposited by screen printing.
